# EUROPEAN PATENT APPLICATION

(11) **EP 1 045 174 A2**
(43) Date of publication of application: **18.10.2000**
(21) Application number: 00107092.9
(22) Date of filing: 05.04.2000
(51) Int. Cl.: F16J 15/10

(54) **Gasket fitted to frame and process for producing the same**

(30) Priority: 13.04.1999 JP 10470099; 09.06.1999 JP 16251699; 29.07.1999 JP 21451499; 18.11.1999 JP 32820699; 18.11.1999 JP 32820899; 06.12.1999 JP 34580899; 18.02.2000 JP 2000040926
(71) Applicant: Bridgestone Corporation, Tokyo 104-8340 (JP)
(72) Inventor: Nishimuro, Youichi, Kunitachi-shi, Tokyo (JP); Koyama, Haruo, Iruma-shi, Saitama-ken (JP); Machida, Kunio, Tokyo (JP)
(74) Representative: Gille Hrabal Struck Neidlein Prop Roos

(57) **Abstract**

A gasket fitted to a frame, in which the gasket is fixed to the lateral side of a frame body, features that it meets the performance of both rigidity and sealing property, can be placed in a narrow clearance and is lightweight; a gasket fitted to a frame, in which a frame body comprises an outer frame body and an inner frame body integrated with each other, the gasket is integrated with the outer frame body and inner frame body, features the capability of sealing by one time attachment, the portion inside a cover body needing seal without using plural gaskets; a gasket fitted to a frame, in which the gasket is integrated with both the whole outer side of the frame body and part of the inner side thereof, features the fact just mentioned; a gasket fitted to a frame, in which uneven and irregular portions are installed on the molding surface of the frame body, features lightweightness and excellent sealing properties without causing a dent on the gasket; a gasket fitted to a frame, in which at least one hole and/or at least one notch are each installed in the frame body features lightweightness and excellent sealing properties without causing dislocation in a mold due to molding shrinkage; and a gasket fitted to a frame, in which a positioning portion composed of the same synthetic resin as in the frame body is fixed onto the gasket lateral side in the opposite lateral side where the gasket is fixed onto the frame body, features the capability of being correctly inserted at a prescribed position of a box body without causing any dislocation when the gasket is covered with a cover body.

## Description

### BACKGROUND OF THE INVENTION

### 1. Field of the Invention

The present invention relates to a gasket fitted to a frame and a process for the production of said gasket fitted to a frame. More particularly, the present invention pertains to a gasket which is fitted to a frame and hermetically seals the joint surface between a cover body and a main body in lightweight electronic equipment, for instance, hard disc equipment of a computer; and a process for the production of said gasket fitted to a frame. The gasket fitted to a frame according to the present invention can be installed in a narrow clearance, and is applicable to techniques for hermetically sealing the hard disc equipment, etc. of a computer installed inside a robot in an automatic manufacturing line or the like so as to completely keep water and air away from the equipment, etc.

### 2. Description of the Related Arts.

The development of electronic equipment in recent years really amazes the persons concerned. The aforesaid equipment, which is subjected to printed circuit on a substrate by the use of integrated circuits utilizing semiconductors, is directed to compactified lightweight equipment, and is prone to be readily damaged by moisture or dampness in particular. Accordingly, the hermetically sealing performance of a gasket is a factor of importance for the performance and durability of the electronic equipment, which gasket is used for hermetic ally sealing the joint surface between a cover body and a box type main body having built-in integrated circuits as mentioned above.

It is customary for the purpose of hermetical sealing to integrate a cover body and a box type main body having built-in integrated circuits into equipment by interposing a gasket which hermetically seals the joint surface between said both the bodies and tightening them with fixing bolts. There has heretofore been used a high density urethane foam material as a gasket material. The urethane foam material is in the form of thin sheet foam, and is used in many cases by sticking an adhesive tape on the urethane sheet foam and punching the sheet foam into a prescribed shape. However, the gasket was difficult to install in a prescribed position because of its being soft. Thus there is used a gasket which is formed by heating and molding a foam of polyurethane foam or the like integrally with both sides of a sheet composed of polypropylene, polyethylene terephthalate or the like, and then punching the integrated sheet into a prescribed shape of gasket { refer to Japanese Patent Registration No. 2507197 [ Japanese Patent Application Laid-Open No. 89562 /1994 (Heisei-6)] and Japanese Patent Application Laid-Open No. 183964 / 1997 ( Heisei-9 ) }. However the resultant resin sheet, which has low rigidity as compared with that of a metallic frame body as described hereinafter, is apt to cause dislocation during its use. In order to prevent such dislocation, the above-mentioned resin gasket is stuck to a cover body prior to use.

In addition, there is proposed a gasket in which an elastomer is fixed to both sides of a frame body, and which is manufactured by inserting into a mold, a frame body composed of stainless steel or a synthetic resin, and then injection molding the elastomer onto the frame body { refer to Japanese Patent Application Laid-Open No. 283698/ 1996 (Heisei-8)}. As a gasket fitted to a frame, there is proposed the gasket in which rubber such as EPDM is arranged on and integrated with both sides of a metallic frame body having a large number of small holes { refer to Japanese Patent Application Laid-Open No. 341986/ 1992 (Heisei-4)}. By adopting a frame body, the aforesaid gaskets are imparted with rigidity, and are improved in attachability to equipment and machinery.

In the case of using the gasket fitted to a frame body having an elastomer fixed to both sides thereof by interposing the gasket on the joint surface between a box body and a cover body, the gasket is pressed by such an action that several plain portions which have prescribed height and are installed on the box body, pushingly come into contact with the cover body, and thus the gasket is pressed at the place where the box body and cover body are out of pushing contact, thereby hermetically sealing the joint surface between the cover body and box body. The pressed amount, that is, the decrease in gasket thickness at the place where the box body and cover body are out of contact, is determined by the height of the plain portions installed on the box body, that is, the clearance between the box body and cover body that are out of contact with each other.

The clearance for such a gasket as well as the width of the clearance are increasingly made narrower year by year, accompanying the compactification of hard disc equipment. Thus, it is difficult to design a frame body having high rigidity despite its narrow width so as to match the narrow clearance. The reason is that in order to simultaneously impart both rigidity and sealing property to the gasket fitted to a frame in which an elastomer as the gasket material is placed on both sides of a rigid frame body, it is needed to increase to some extent, the thickness of the gasket in question. In particular, when an attempt is made to fabricate a frame body with a synthetic resin for the purpose of lowering the weight and manufacturing cost of the frame body, the frame body made therewith is required to have a thickness about 3 to 5 times that of a metallic frame body because of the rigidity of the resin being low as compared with that of a metal. Accordingly, it is difficult to apply a frame body made of a synthetic resin to a narrow clearance between the box body and cover body. In addition, since the previous gasket fitted to a frame has been formed in the form of the gasket along the outside periphery of the cover body, it has been necessary to use at least one other gasket on a sealing portion ( for instance, a sealing portion of a connector ) inside the cover body. Moreover, the previous gasket fitted to a frame has been involved in the problem of dislocation of a gasket, when covered thereon with the cover body.

There is also proposed a gasket fitted to a frame in which a frame body made of a thermoplastic resin and a gasket made of a thermoplastic elastomer are integrated with each other { refer to Japanese Utility Model Application Laid-Open No.138284/ 1989 (Heisei-1)}. In preparing such gasket fitted to a frame, there is adopted a method in which a frame body made of a thermoplastic resin is firstly molded by injection molding, and a gasket is formed on the resultant frame body by filling a thermoplastic elastomer in a cavity of a mold arranged along the frame body so that the frame body and the gasket are integrated with each other.

In the case where a thermoplastic elastomer is filled in a cavity of a mold, the molding system is so designed that air remaining in the cavity of the mold and gases generated from the thermoplastic elastomer are gradually exhausted to the outside of the mold through the clearance in gas bent grooves which are provided in the mold and which have a depth in the range of approximately 1/100 to 5/100 mm. In particular, in the case of producing, by injection molding, a gasket fitted to a frame which has a small cross sectional area and is used for an HDD (hard disc drive), utmost importance is attached to setting up sufficient gas bent grooves. The reason for this is that the filling rate of the thermoplastic elastomer in the cavity of a mold, when being not enhanced, results in failure to fill the elastomer in every nook and corner of the mold, whereas said rate, when being enhanced, brings about the trouble that air remaining in the cavity of the mold and gases generated from the thermoplastic elastomer are not sufficiently discharged, but are prone to be accumulated in a weld portion where said elastomer is merged, thus generating a dent in the weld portion with the result that a dent is generated on the gasket to be produced.

On the other hand, in the case where the gasket fitted to a frame is fabricated by two-color molding method or injection molding method, at the time when the frame body formed in advance by using a thermoplastic resin is interposed in the mold in which the thermoplastic elastomer is filled, it is necessary to firmly press the frame body with the mold in order that the thermoplastic elastomer may not be squeezed out through the clearance between the frame body and the mold. However when the frame body is firmly pressed with the mold, the frame body, when made of a resin, deforms and plugs up gas bent grooves that are provided in the mold. Consequently, the air and gas are made impossible to be exhausted from the mold resulting in the generation of a dent on the weld portion, thereby causing the problem that a dent is generated on the gasket to be formed.

As a process for producing the above-mentioned gasket fitted to a frame in which the frame body made of a thermoplastic resin and the gasket made of a thermoplastic elastomer are integrated with each other, there is preferably adopted a two-color molding method in which a frame body made of a thermoplastic resin is firstly molded by injection molding, and a gasket is formed on the resultant frame body by filling a thermoplastic elastomer in a cavity of a mold arranged along the frame body so that the frame body and the gasket are integrated with each other. By the term two-color molding method is meant a molding method comprising rotatably moving the resin molding formed with a primary mold to the side of a secondary mold engraved with the configuration to which a prospective elastomer conforms without taking out from the primary mold, and injection molding the elastomer into the space between the primary mold and the secondary mold so as to mold the elastomer simultaneously with fusedly integrating the elastomer and the resin molding.

In the case where the gasket fitted to a frame is fabricated by means of the aforesaid two-color molding method, at the time when the frame body formed with a primary mold by using a thermoplastic resin, is rotatably moved to the side of a secondary mold in a state of being housed in the primary mold, there is often caused such a trouble that the molding contraction of the thermoplastic resin deforms the frame body, causing dislocation of the frame body from the prescribed position at which the frame body is housed in the primary mold, thereby making it impossible to mold the gasket fitted to a frame to the prescribed shape, even when the elastomer is filled in the space housing the frame body between the primary mold and the secondary mold.

### SUMMARY OF THE INVENTION

Under such circumstances, it is a general object of the present invention to provide a lightweight gasket fitted to a frame which satisfies both rigidity and sealing property, and is capable of being installed even in a narrow clearance.

It is another object of the present invention to provide a gasket fitted to a frame which satisfies both rigidity and sealing property, and which enables such a portion as needing sealing in the inside of the cover body to be sealed by one time fitting without the use of a plurality of gaskets.

It is still another object of the present invention to provide a lightweight gasket fitted to a frame which is excellent in sealing property without generating any dent on the gasket.

It is a further object of the present invention to provide a lightweight gasket fitted to a frame which is excellent in sealing property without generating any dislocation due to molding contraction in a mold for the frame body composed of a thermoplastic resin.

It is a still further object of the present invention to provide a lightweight gasket fitted to a frame which satisfies both rigidity and sealing property, and which is capable of being installed in narrow clearance, and correctly inserted into a prescribed position in a box body without generating any dislocation of the gasket, even when the gasket is covered thereon with a cover body.

Other objects of the present invention will be obvious from the text of the specification hereinafter disclosed.

In view of the foregoing, intensive extensive research and investigation were accumulated by the present inventors in order to achieve the above-mentioned objects. As a result, it has been found that there is obtainable a gasket fitted to a frame which has both desired rigidity and excellent sealing property without the need of increasing the total thickness of the gasket even when it is made of a synthetic resin, by arranging the gasket on the lateral side of the frame body in said gasket fitted to a frame.

It has also been found that there is obtainable a gasket fitted to a frame which has both desired rigidity and excellent sealing property, and which enables such a portion as needing sealing in the inside of the cover body to be sealed by one time fitting simultaneously with the sealing of the outside periphery of the cover body, by constituting a frame body of an outer frame body and an inner frame body that are integrated with each other, and integrating these frame bodies with the gasket, or by integrating the whole outer side of the frame body, part of the inner side thereof and the gasket.

It has further been found that there is obtainable a lightweight gasket fitted to a frame which has excellent sealing property without generating a dent on the weld portion of an elastomer by installing uneven and irregular portions on the molding surface of the frame body at the time of producing the gasket fitted to a frame body, thereby making it possible to assure a sufficient clearance between the mold and the frame body, even when the frame body is firmly inserted in the mold.

It has still further been found that there is obtainable a lightweight gasket fitted to a frame having excellent sealing property without generating any dislocation due to molding contraction in a mold for the frame body when the frame body formed in a primary mold is introduced in a secondary mold, by installing a hole and/or a notch in the frame body in preparing the gasket fitted to a frame body.

It has furthermore been found that there is obtainable a lightweight gasket fitted to a frame having desired rigidity and excellent sealing property without the need of increasing the total thickness of the gasket even when the frame body is made of a synthetic resin, without generating any dislocation of the gasket, even when the gasket is covered thereon with a cover body, by arranging the gasket on the lateral side of the frame body in said gasket fitted to a frame, and further fixing a positioning portion composed of the synthetic resin same as that of the frame body, onto the gasket lateral side in the opposite lateral side where it is fixed to the frame body.

It being so, the present invention has been accomplished on the basis of the foregoing findings and information.

Specifically, the present invention provides a gasket integrally fitted to a frame (I ), characterized in that a frame body comprises a synthetic resin, the gasket comprises an elastic body, and said gasket is fixed to the lateral side of the frame body; and a process for producing said gasket fitted to a frame (I ) which comprises integrating said gasket and frame body by injection molding method or two-color molding method.

In addition, the present invention provides a gasket integrally fitted to a frame (II ), characterized in that a frame body comprises an outer frame body and an inner frame body that are integrated with each other, and the gasket comprises an elastic body, and is integrated with said outer frame body and inner frame body; and a process for producing said gasket fitted to a frame (II ) which comprises integrating said gasket and frame body by injection molding method or two-color molding method.

Also, the present invention provides a gasket integrally fitted to a frame (III ), characterized in that the gasket comprises an elastic body, and is integrated with both the whole outer side of the frame body and part of the inner side thereof; and a process for producing said gasket fitted to a frame (III ) which comprises integrating said gasket and frame body by injection molding method or two-color molding method.

Moreover, the present invention provides a gasket integrally fitted to a frame (IV ), characterized in that a frame body comprises a thermoplastic resin, the gasket comprises a thermoplastic elastomer, and uneven and irregular portions are each installed on the molding surface of the frame body; and a process for producing said gasket fitted to a frame (IV ) which comprises integrating said gasket and frame body by injection molding method or two-color molding method.

Further, the present invention provides a gasket integrally fitted to a frame (V ), characterized in that a frame body comprises a thermoplastic resin, the gasket comprises a thermoplastic elastomer, and at least one hole and/or at least one notch are each installed in the frame body; and a process for producing said gasket fitted to a frame (V ) which comprises integrating said gasket and frame body by two-color molding method.

Furthermore, the present invention provides a gasket integrally fitted to a frame (VI ), characterized in that a frame body comprises a synthetic resin, the gasket comprises an elastic body, said gasket is fixed on the lateral side of the frame body, and further a positioning portion composed of the synthetic resin same as that of the frame body is fixed onto the gasket lateral side in the opposite lateral side where the gasket is fixed onto the frame body; and a process for producing said gasket fitted to a frame (VI ) which comprises integrating said gasket and frame body by injection molding method or two-color molding method.

### BRIEF DESCRIPTION OF THE DRAWINGS

FIG.1 is a perspective illustration which shows one example of gasket fitted to a frame (I ) according to the present invention;
FIG.2 is a cross sectional view taken on the line A-A of FIG.1 which shows the gasket fitted to a frame body;
FIG.3 is a perspective illustration which shows another example of gasket fitted to a frame (I ) according to the present invention;
FIG.4(A) is a cross sectional view taken on the line B-B of FIG.3 which shows the gasket fitted to a frame body;
FIG.4 (B) and (C) are each a perspective illustration which shows other examples of gasket fitted to a frame relating to FIG.3;
FIG.5 is a cross sectional view which shows one example of gasket configuration for the gasket fitted to a frame (I ) according to the present invention;
FIG.6 is a cross sectional view which shows the gasket fitted to a frame of Comparative Example 1;
FIG.7 is a cross sectional view which shows the gasket fitted to a frame of Comparative Example 2;
FIG.8 is a perspective illustration which shows one example of gasket fitted to a frame (II ) according to the present invention;
FIG.9(A) is an enlarged cross sectional view taken on the line A-A of FIG.8 which shows the gasket fitted to a frame (II );
FIG.9(B) is an enlarged cross sectional view which shows another gasket configuration for the gasket fitted to a frame (II );
FIG.10 is a perspective illustration which shows one example of gasket fitted to a frame (III ) according to the present invention;
FIG.11 is a perspective illustration which shows the gasket fitted to a frame of Comparative Example 3;
FIG.12 is an enlarged cross sectional view taken on the line B-B of FIG.11 which shows the gasket fitted to a frame;
FIG.13 is a perspective illustration which shows one example of gasket fitted to a frame (IV ) according to the present invention;
FIG.14 is a cross sectional view taken on the line A-A of FIG.13 which shows the gasket fitted to a frame;
FIG.15 is a cross sectional view which shows a production process for the gasket fitted to a frame of Example 3;
FIG.16 is a cross sectional view which shows part of a production process for the gasket fitted to a frame of Example 4;
FIG.17 is a cross sectional view which shows a production process for the gasket fitted to a frame of Comparative Example 4;
FIG.18 is a perspective illustration which shows one example of gasket fitted to a frame (V ) according to the present invention;
FIG.19 is a cross sectional view taken on the line A-A of FIG.18 which shows the gasket fitted to a frame;
FIG.20 is a cross sectional view which shows a production process for the gasket fitted to a frame of Example 5;
FIG.21 is a plan view which shows the gasket fitted to a frame f Example 5;
FIG.22 is a plan view which shows the gasket fitted to a frame of Comparative Example 5;
FIG.23 is a plan view which shows one example of gasket fitted to a frame (VI ) according to the present invention;
FIG.24 is a cross sectional view taken on the line A-A of FIG.23 which shows the gasket fitted to a frame; and
FIG.25 is a cross sectional view which shows one example of gasket configuration for the gasket fitted to a frame (VI ) according to the present invention.

### DESCRIPTION OF THE PREFERRED EMBODIMENTS

The synthetic resin which constitutes the frame body in the gasket fitted to a frame according to the present invention may be properly selected from among acrylonitrile styrene (AS) resin, acrylonitrile butadiene styrene (ABS) resin, styrenic resin such as polystyrene and syndiotactic polystyrene, olefinic resin such as polyethylene, polypropylene, polypropylene complex exemplified by ethylene/propylene copolymer, polyamide resin such as nylon, polyester based resin such as polyethylene terephthalate and polybutylene terephthalate, modified polyphenylene ether, acrylic resin, polyacetal, polycarbonate, a liquid crystal polymer, polyphenylene sulfide (PPS) and the like. The liquid crystal polymer is preferably a thermotropic liquid crystal polymer, which is classified into those of polycarbonate base, polyurethane base, polyamide base, polyester base and the like, respectively. Any one of the above-exemplified thermoplastic resins is properly selected and may be used alone or in combination with at least one other resin mentioned above. Of these are preferable polypropylene and polypropylene complex in the present invention from the viewpoint of their excellent sealing properties and being capable of fused adhesion to styrenic elastomers that are characterized by low hardness.

In regard to an elastic body which constitutes the gasket according to the present invention, there are usable vulcanized rubber such as butyl rubber and EPDM and thermoplastic elastomer. As the thermoplastic elastomer there are usable styrenic, olefinic, urethane based and ester based thermoplastic elastomers, of which is preferably usable in particular the copolymer comprising at least one polymer block composed principally of a vinylic aromatic compound and at least one polymer block composed principally of a conjugated diene compound.

More specific examples of said elastomers include:
① Block copolymer of crystalline polyethylene and ethylene/ butylene styrene random copolymer, said block copolymer being obtained by hydrogenating block copolymer of polybutadiene and butadiene-styrene random copolymer; and
② Block copolymer of polybutadiene and polystyrene, block copolymer of polyisoprene and polystyrene, diblock copolymer of crystalline polyethylene and polystyrene, said diblock copolymer being obtained by hydrogenating block copolymer of polybutadiene or ethylene-butadiene random copolymer and polystyrene, triblock copolymer ( SEBS ) of styrene-ethylene/ butylene-styrene, and triblock copolymer ( SEPS ) of styrene-ethylene/ propylene-styrene, in particular, block copolymer of styrene-ethylene/ butylene-styrene, and block copolymer of styrene-ethylene/ propylene-styrene. Any one of the above-exemplified thermoplastic elastomers may be used alone or in combination with at least one other elastomer mentioned above.

No specific restriction is imposed upon the combination of the thermoplastic resin as a material of the frame body and the thermoplastic elastomer as a material of the gasket. There are exemplified the combination of olefinic resin and styrenic elastomer or olefinic elastomer, the combination of nylon or ABS resin and urethane based elastomer, and the like.

The thermoplastic resin or the thermoplastic elastomer can be imparted with an antistatic property by adding thereto, a filler capable of imparting electroconductivity thereto. By imparting an antistatic property, it is made possible to prevent dust or dirt from sticking to the gasket and frame body in the production step of the gasket fitted to a frame. Examples of fillers capable of imparting electroconductivity include powders and fibers of a metal such as iron, stainless steel and aluminum, electroconductive fillers such as carbon black and carbon fiber and antistatic agents such as polyalkylamine, polyalkylsulfonate, quaternary ammonium chloride and alkylbetaine.

The amount of said fillers to be added to the thermoplastic resins or thermoplastic elastomers is preferably such an amount that the resins or elastomers are made to have each a volume resistivity of at most 1× 10⁸ Ω cm. When the frame body is required to have properties of shielding electromagnetic wave, the volume resistivity is preferably at most 1× 10² Ω cm. Said elastomers, when incorporated with any of the fillers, have each JIS hardness A of preferably at most 80 degrees, particularly preferably in the range of 10 to 50 degrees.

It is possible in the present invention to add a reinforcing material to the foregoing thermoplastic resins or thermoplastic elastomers to the extent that the effects of the present invention are not impaired. Said reinforcing material is exemplified by inorganic fiber such as glass fiber and carbon fiber, inorganic filler such as mica and talc, and whiskers of potassium titanate and the like.

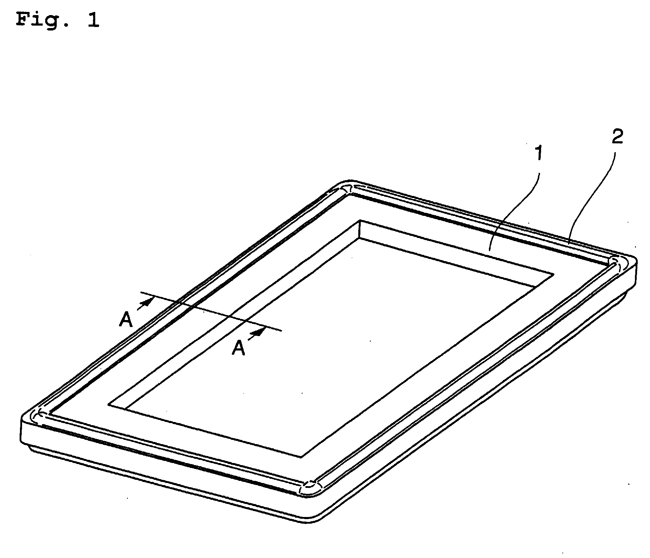

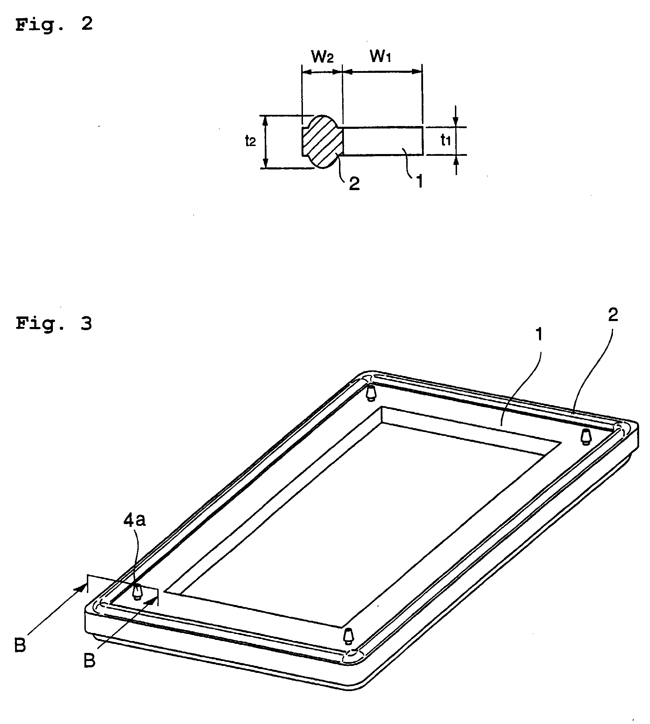

In the gasket fitted to a frame (I ) according the to the present invention, the gasket is fixed to the lateral side of the frame. The gasket is used in such a manner that it is interposed on the joint surface between a cover body and a box body which houses integrated circuits or the like. FIG.1 is a perspective illustration which shows one example of gasket fitted to a frame (I ) according the to the present invention. FIG.2 is an enlarged cross sectional view taken on the line A-A of FIG.1. As illustrated in FIG.1 and 2, the gasket fitted to a frame (I ) according to the the present invention enables itself to have rigidity for the purpose of retaining its shape by fixing a gasket 2 to the lateral side of a frame body 1 and increasing the thickness of the frame body 1 without increasing the total thickness (refer to t₂ in FIG.2) of the gasket. Moreover, the gasket can be made into a shape desirable for satisfying the sealing properties. The gasket fitted to a frame, although showing one example wherein the gasket is fixed to the outer peripheral side of the frame in FIG.1 and 2, may be in such a form that the gasket is fixed to the inner peripheral side thereof.

In the gasket fitted to a frame (I ) proper and arbitrary selection is made for the thickness (refer to t₁ in FIG.2) and width ( refer to w₁ in FIG.2) of the frame body, and total thickness ( refer to t₂ in FIG.2) and width ( refer to w₂ in FIG.2) of the gasket in accordance with the purpose of use of the gasket fitted to a frame and the like. In order to assure sufficient rigidity thereof, the frame body has a thickness of preferably at least 0.1 mm. In the case where the frame body has a thickness in the range of 0.1 to 1.2 mm, it can have a width of 0.5 to 5.0 mm, preferably 1.0 to 3.0 mm, the gasket can have a total thickness of 0.8 to 2.5 mm, preferably 1.2 to 1.8 mm and a width of 0.5 to 2.5 mm, preferably 0.8 to 1.5 mm.

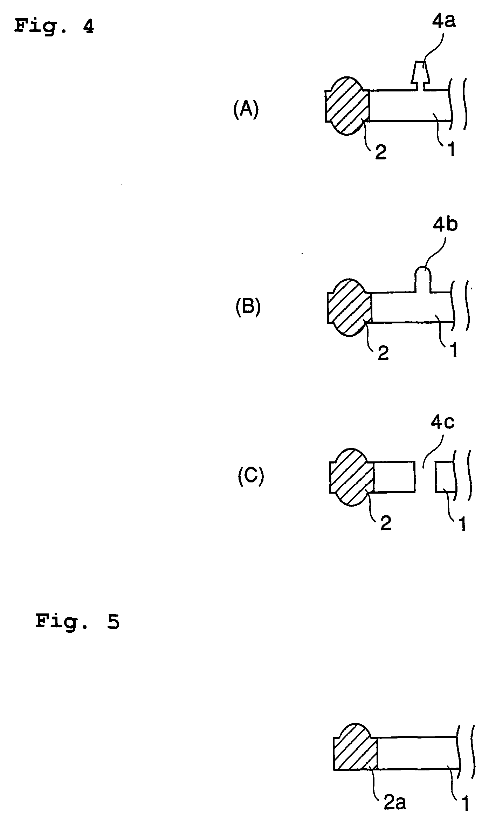

FIG.3 is a perspective illustration which shows a gasket fitted to a frame in which the gasket fitted to a frame shown on FIG.1 is equipped further with a fitting portion for a box body or a cover body, and FIG.4 (A) is an enlarged cross sectional view taken on the line B-B of FIG.3. In the case where the frame body 1 is equipped with a protruding portion 4a as the fitting portion, a box body or a cover body preferably has a hole portion for allowing the protruding portion 4a to fit thereinto. FIG.3 shows an example of frame body 1 having four protruding portions at four corners. However, the frame body may be equipped with a desired number of protruding portions at desired positions without any limitation on the position or the number thereof. The shape of the protruding portion is not limited to that of 4a, but may be cylindrical shape with round end as shown by 4b in FIG.4 (B). The fitting portion to be arranged on the frame body 1 is not limited to a protruding portion, but may be a hole portion 4c formed thereon as shown in FIG.4 (C). In the case where the frame body 1 is equipped with hole portion 4c as the fitting portion, a box body or a cover body preferably has a protruding portion such as the protruding portion 4a or 4b. Herein, proper and arbitrary selection may be made for the sizes of the protruding portion and hole portion. FIG.3 and 4 show each an example of frame body 1 which fits with either a box body or a cover body, but said frame body may fit with both of them. In the case where the frame body 1 fits with either a box body or a cover body, it preferably fits with a box body from the standpoint that the protruding portion for fitting is prevented from protruding out from the surface of equipment.

On the one hand, the shape of the gasket may be convex both upwards and downwards for the frame body 1 as shown by the gasket 2 in FIG.2 and so forth, or may be convex only upwards for the frame body 1 as shown by the gasket 2a in FIG.5.

The integration of the frame body and the gasket is made by the junction between the thermoplastic resin constituting the frame body and the thermoplastic elastomer constituting the gasket, specifically by means of two-color molding method, inserting molding method or the like.

By means of the two-color molding method, there is formed the composite gasket fitted to a frame (I ) in which the thermoplastic resin is integrated with the thermoplastic elastomer layer formed on the lateral side thereof through the steps of firstly subjecting the thermoplastic resin constituting the frame body to melt injection molding into a mold with an injection molding machine for exclusive use to obtain a frame body of a thermoplastic resin molding having a fitting portion as required, and after the molding thus formed is solidified, subjecting the thermoplastic elastomer which is excellent in fusion adhesivity to said thermoplastic resin, to melt injection molding with an injection molding machine for exclusive use so as to form a gasket portion composed of the thermoplastic elastomer layer on the portion excluding the fitting portion of the frame body of the thermoplastic resin molding. The two-color molding method is capable of producing composite gasketed covers in high production efficiency at a low cost.

On the other hand, by means of the inserting molding method, there is obtained the composite gasket fitted to a frame (I ) in which the thermoplastic resin constituting the frame body is integrated with the thermoplastic elastomer layer formed on the lateral side of the thermoplastic resin through the steps of preparing in advance, the frame body having a prescribed shape by any of various well known molding methods, placing the resultant frame body in a mold, and then forming the thermoplastic elastomer layer on part of the frame body.

The gasket fitted to a frame(I ) according to the present invention has such a configuration that the gasket is fixed to the lateral side of the frame body. The aforesaid configuration is enabled merely by the constitution wherein the frame body comprising the thermoplastic resin and the gasket comprising the elastic body are integrated with each other by means of fusion adhesion. It is extremely difficult to realize such configuration with a gasket fitted to a frame by the use of a metallic frame or a punched product comprising a resin sheet and a foam. Moreover, it is made possible to dispense with a rust preventive step and reduce the weight of the product owing to the nonuse of a metallic material, whereby the gasket fitted to a frame (I ) according to the present invention is well suited for use in compactified hard disc units. Further it is made possible to efficiently produce the same using a single mold in high accuracy and precision at a low cost owing to the use of a synthetic resin, and to recycle said resin.

As the material constituting a covet body or a box body in which is used the gasket fitted to a frame (I ), there are usable a variety of synthetic resins typified by the above-mentioned thermoplastic resins, metals such as aluminum, iron, stainless steel and magnesium, alloys and the like.

As described hereinbefore, the gasket fitted to a frame (I ) according to the present invention satisfies the performance of both rigidity and sealing properties, can be installed in a narrow space and has lightweight properties.

As the material constituting the gasket fitted to a frame (II ) or (III ) according to the present invention, there are usable a metallic sheet, a synthetic resin and the like. The metallic sheet can be properly arbitrarily selected for use according to the purpose of use thereof from cold rolled steel sheets, galvanized steel sheets, aluminum/zinc alloy plated steel sheets, stainless steel sheets, aluminum sheets, aluminum alloy sheets, magnesium sheets, magnesium alloy sheets, and the like. There are also usable injection molded magnesium sheets. From the viewpoint of corrosion resistance, there are preferably usable metallic sheets treated with non-electrolytic nickel plating, As the non-electrolytic nickel plating, there can be used a conventional method which has heretofore been applied to metallic raw material such as a method which comprises immersing a metallic sheet to be treated in a non-electrolytic nickel plating bath consisting of an aqueous solution at a pH of 4.0 to 5.0 approx. at a temperature of 85 to 95°C approx. which contains, for instance, nickel sulfate, sodium hypochlolite, lactic acid, propionic acid and the like each at a proper proportion. As the synthetic resin, there are preferably usable the synthetic resins same as those exemplified in the gasket fitted to a frame (I ).

In regard to an elastic body which constitutes the gasket in the gasket fitted to a frame (II ) or (III ), there are preferably usable those exemplified in the gasket fitted to a frame (I ). Likewise, as fillers capable of imparting electroconductivity and reinforcing materials, there are preferably usable those exemplified in the gasket fitted to a frame (I ). The volume resistivity and JIS hardness A are each preferably in the same range as in the gasket fitted to a frame (I ).

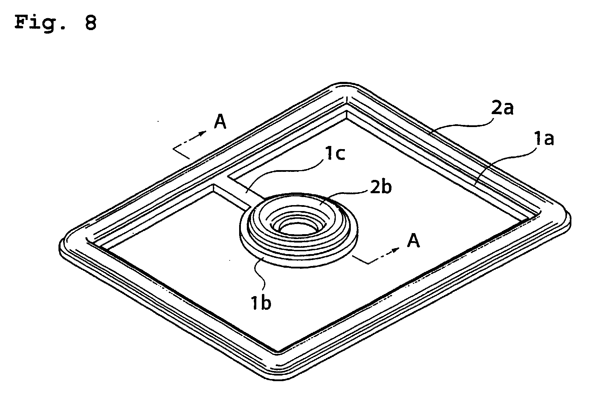

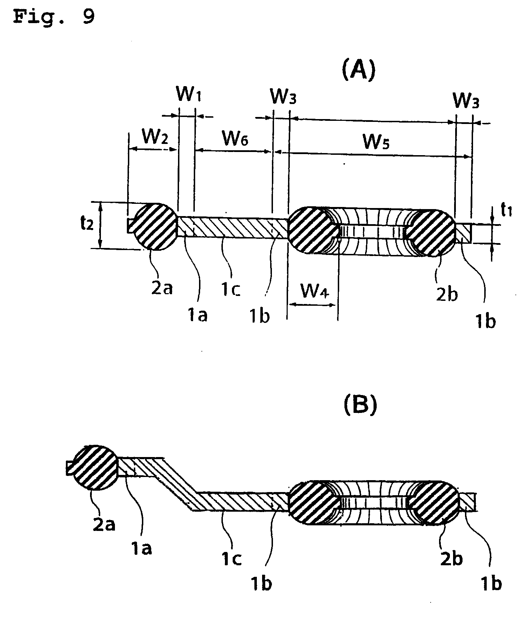

In the case where the frame body is constituted of a synthetic resin in the gasket fitted to a frame (II ) or (III ) according to the present invention, the gasket can be made into the shape in which it is fixed to the lateral sides of an outer frame and an inner frame. By such shape, the gasket can be installed in a narrow clearance. FIG.8 is a perspective illustration which shows one example of gasket fitted to a frame (II ) according to the present invention, and FIG,9(A) is an enlarged cross sectional view taken on the line A-A of FIG.8. As illustrated in FIG.8 and 9(A), the gasket fitted to a frame (II ) enables itself to have lightweight properties and rigidity for the purpose of retaining the shapes of an outer frame body 1a and inner frame body 1b by fixing gasket 2a to the lateral side of the outer frame body 1a and gasket 2b to the lateral side of the inner frame body 1b without increasing the total thickness { t₂ in FIG.9(A) } of the gaskets 2a and 2b, even if the frame bodies are made of a synthetic resin. Moreover, the gaskets 2a and 2b can be made each into a shape desirable for satisfying the sealing properties. In this gasket fitted to a frame, by installing the inner frame body 1b inside the outer frame body 1a, and integrating the inner frame body 1b and the outer frame body 1a by means of a rod body 1c, the cover body inside can be sealed by one time fitting without using a plurality of gaskets.

Although the gasket fitted to a frame in FIG.8 and 9(A) indicates the case of the total thickness { refer to t₂ in FIG.9(A) } of the gaskets 2a and 2b being the same, said thickness can be made different from each other, when the clearances of sealing portions are different from each other. In addition, by adopting the cross sectional shape as shown in FIG.9(B) the gasket can be used in a place having difference in level.

In the gasket fitted to a frame (II ) according the to the present invention, proper and arbitrary selection is made for the thickness { refer to t₁ in FIG.9(A)} and width { refer to w₁ and w₃ in FIG.9(A)} of the frame body, and total thickness { refer to t₂ in FIG.9(A)} and width { refer to w₂ and w₄ in FIG.9(A)} of the gasket in accordance with the purpose of use of the gasket fitted to a frame and the like. In order to assure sufficient rigidity thereof, the frame body has a thickness of preferably at least 0.1 mm. In the case where the frame body has a thickness in the range of 0.1 to 1.2 mm, it can have a width of 0.5 to 5.0 mm, preferably 1.0 to 3.0 mm, the gasket can have a total thickness of 0.8 to 2.5 mm, preferably 1.2 to 1.8 mm and a width of 0.5 to 2.5 mm, preferably 0.8 to 1.5 mm.

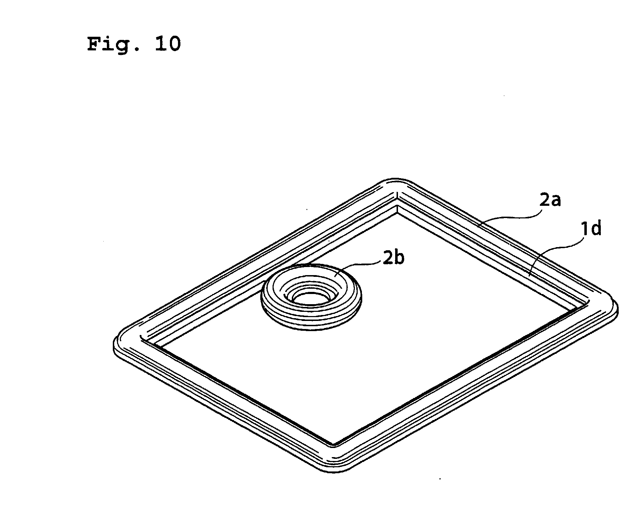

The gasket fitted to a frame (III ) as illustrated in FIG. 10 has such a configuration that the gasket fitted to a frame as illustrated in FIG.8 is devoid of an inner frame body 1b and a rod body 1c, and the gasket 2b is fixed to the inner lateral side of the frame body 1d. The dimensions of the portions in the gasket fitted to a frame in FIG.10 may be the same as the dimensions of the same portions in that in FIG.8.

On the one hand, the shape of the gasket may be convex both upwards and downwards for the frame body 1a, etc. as shown by the gaskets 2a and 2b in FIG.9, or may be convex only upwards for the frame body 1a, etc.

The integration of the frame body and the gasket, in the case of the material constituting the gasket being a thermoplastic elastomer, is made by injection molding the gasket to shape onto the frame body. In the case where the frame body material is a thermoplastic resin, and the gasket material is a thermoplastic elastomer, the integration thereof is made by the junction between the thermoplastic resin and thermoplastic elastomer, specifically by two-color molding method, inserting molding method or the like. The details of these methods are as explained in the description of the gasket fitted to a frame (I ).

In the case where the frame body is constituted of a synthetic resin in the gasket fitted to a frame (II ) or (III ) according to the present invention, it is made possible to exhibit the working effects same as those in the aforesaid gasket fitted to a frame (I ).

As the material constituting a cover body or a box body in which is used the gasket fitted to a frame (II ) or (III ) according to the present invention, there are usable various synthetic resins typified by the above-mentioned thermoplastic resins, metals such as aluminum, iron, stainless steel and magnesium, alloys and the like.

As described hereinbefore, the gasket fitted to a frame (II ) or (III ) according to the present invention satisfies the performance of both rigidity and sealing properties, and enables such portions that need sealing inside the cover body to be sealed by one time fitting without using a plurality of gaskets.

As the thermoplastic resin constituting the frame body in the gasket fitted to a frame (IV ) according to the present invention, there are preferably usable the thermoplastic resins same as those exemplified in the gasket fitted to a frame (I ). Moreover, as the thermoplastic elastomer constituting the gasket in the gasket fitted to a frame (IV ), there are preferably usable the thermoplastic elastomer same as those exemplified in the gasket fitted to a frame (I ). Likewise, as fillers capable of imparting electroconductivity and reinforcing materials, there are preferably usable those exemplified in the gasket fitted to a frame (I ). The volume resistivity and JIS hardness A are each preferably in the same range as in the gasket fitted to a frame (I ).

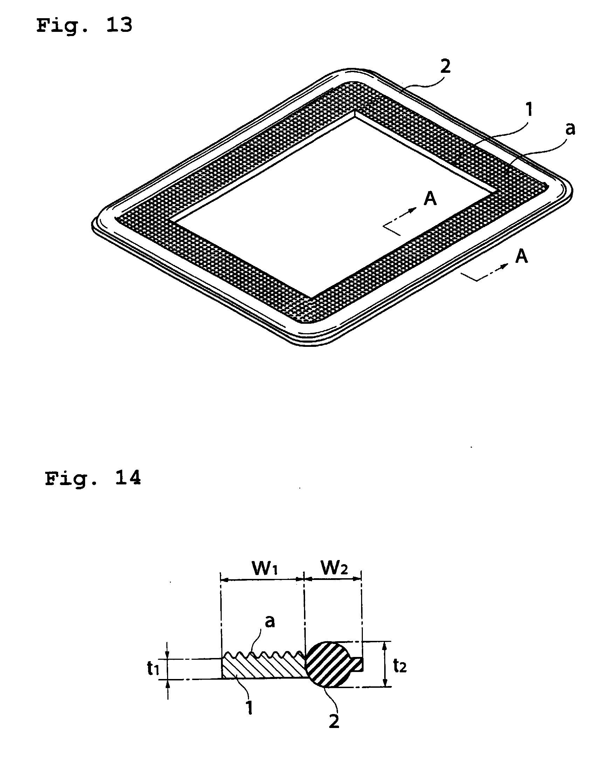

The gasket fitted to a frame (IV ) according to the present invention is equipped with uneven irregular portions on the molding surface of the frame body. FIG.13 is a perspective illustration which shows one example of gasket fitted to a frame (IV ) according to the present invention, and FIG,14 is an enlarged cross sectional view taken on the line A-A of FIG.13. As illustrated in FIG.13 and 14, the gasket fitted to a frame is equipped continuously with protruding portions on the upper surface of the frame body. Such protruding portions may be placed on an other surface thereof, The configuration of the uneven irregular portion is not limited to a protruding portion, but may be grooved surface, contracted surface or knurled surface, any of which can be formed at the time of molding the frame body 1.

The size of the uneven irregular portions can be properly arbitrarily selected. The uneven irregular portions need only to be installed on or around the place where an elastomer weld generates, and need not be installed on all the upper surface of the frame body. In the case of forming grooves as uneven irregular portions, preferably the grooves have each a depth of 1/100 to 10/100 mm, a width of 0.1 to 2 mm and a groove-to groove distance of 0.1 to 5 mm, and are formed perpendicular to the outer periphery of the frame body.

The gasket fitted to a frame as illustrated in FIG.13 and 14 represents one example in which the gasket is fixed to the outer peripheral lateral side of the frame body, but the gasket may be fixed to the inner peripheral lateral side thereof.

In the gasket fitted to a frame (IV ), proper and arbitrary selection is made for the thickness { refer to t₁ in FIG.14 } and width { refer to w₁ in FIG.14 } of the frame body, and total thickness { refer to t₂ in FIG.14 } and width { refer to w₂ in FIG.14 } of the gasket in accordance with the purpose of use of the gasket fitted to a frame and the like. In order to assure sufficient rigidity thereof, the frame body has a thickness of preferably at least 0.1 mm. In the case where the frame body has a thickness in the range of 0.1 to 1.2 mm, it can have a width of 0.5 to 5.0 mm, preferably 1.0 to 3.0 mm, the gasket can have a total thickness of 0.8 to 2.5 mm, preferably 1.2 to 1.8 mm and a width of 0.5 to 2.5 mm, preferably 0.8 to 1.5 mm.

On the one hand, the shape of the gasket may be convex both upwards and downwards for the frame body 1 as shown by the gasket 2 in FIG.14, or may be convex only upwards for the frame body 1.

The integration of the frame body and the gasket is made by the junction between the thermoplastic resin constituting the frame body and the thermoplastic elastomer constituting the gasket, specifically by two-color molding method, inserting molding method or the like. The details of these methods are as explained in the description of the gasket fitted to a frame (I ).

In the gasket fitted to a frame (IV ) according to the present invention, it is made possible to dispense with a rust preventive step and reduce the weight of the product owing to the nonuse of a metallic material, whereby the gasket fitted to a frame (IV ) is well suited for use in compactified hard disc units. Further it is made possible to efficiently produce the same using a single mold in high accuracy and precision at a low cost owing to the use of a synthetic resin, and to recycle said resin.

As the material constituting a cover body or a box body in which is used the gasket fitted to a frame (IV ) according to the present invention, there are usable various synthetic resins typified by the above-mentioned thermoplastic resins, metals such as aluminum, iron, stainless steel and magnesium, alloys and the like.

As described hereinbefore, the gasket fitted to a frame (IV ) according to the present invention is lightweight and has excellent sealing properties without causing any dent on the gasket.

As the thermoplastic resin constituting the frame body in the gasket fitted to a frame (V ) according to the present invention, there are preferably usable the thermoplastic resins same as those exemplified in the gasket fitted to a frame (I ). Moreover, as the thermoplastic elastomer constituting the gasket in the gasket fitted to a frame (V ), there are preferably usable the thermoplastic elastomer same as those exemplified in the gasket fitted to a frame (I ). Likewise, as fillers capable of imparting electroconductivity and reinforcing materials, there are preferably usable those exemplified in the gasket fitted to a frame (I ). The volume resistivity and JIS hardness A are each preferably in the same range as in the gasket fitted to a frame (I ).

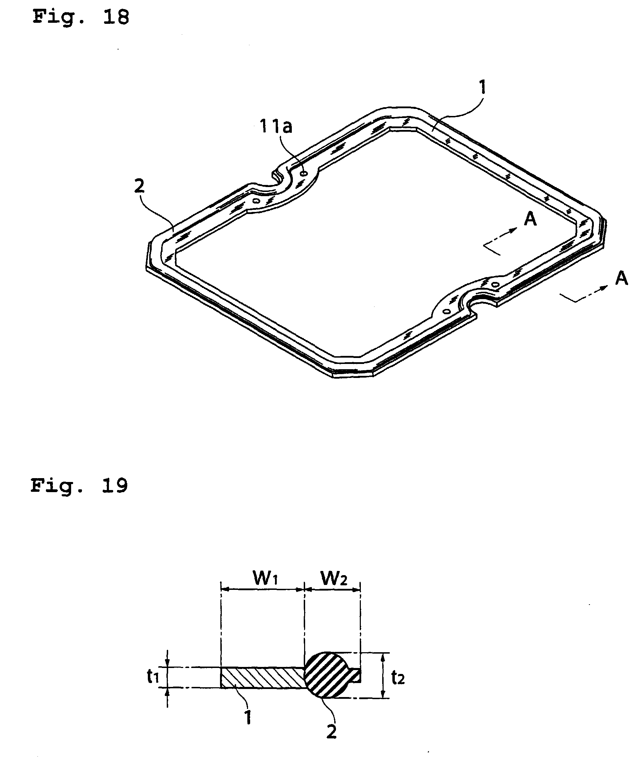

The gasket fitted to a frame (V ) according to the present invention is equipped with at least one hole and/or notch on the frame body. FIG.18 is a perspective illustration which shows one example of gasket fitted to a frame (V ), and FIG,19 is an enlarged cross sectional view taken on the line A-A of FIG.18. As illustrated in FIG.18 and 19, the gasket fitted to a frame is equipped on the frame body with a hole 11a, which may be replaced with a notch. Such hole and/or notch can be formed by setting up a pin at the position corresponding to the hole and/or notch in a mold. The frame body 1, which is fixed to the mold with the pin, is not dislocated from the mold. The sizes of the hole and/or notch can be be properly arbitrarily selected. The hole usually has a diameter of 0.5 to 2.0 mm, and the notch is made to a partial configuration of the hole.

In the gasket fitted to a frame (V ), proper and arbitrary selection is made for the thickness {refer to t₁ in FIG.19} and width { refer to w₁ in FIG.19 } of the frame body, and total thickness { refer to t₂ in FIG.19 } and width {refer to w₂ in FIG.19 } of the gasket in accordance with the purpose of use of the gasket fitted to a frame and the like. In order to assure sufficient rigidity thereof, the frame body has a thickness of preferably at least 0.1 mm. In the case where the frame body has a thickness in the range of 0.1 to 1.2 mm, it can have a width of 0.5 to 5.0 mm, preferably 1.0 to 3.0 mm, the gasket can have a total thickness of 0.8 to 2.5 mm, preferably 1.2 to 1.8 mm and a width of 0.5 to 2.5 mm, preferably 0.8 to 1.5 mm.

On the one hand, the shape of the gasket may be convex both upwards and downwards for the frame body 1 as shown by the gasket 2 in FIG.19, or may be convex only upwards for the frame body 1.

The integration of the frame body and the gasket is made by the junction between the thermoplastic resin constituting the frame body and the thermoplastic elastomer constituting the gasket, specifically by two-color molding method.

By means of the two-color molding method, there is formed the composite gasket fitted to a frame in which the thermoplastic resin is integrated with the thermoplastic elastomer layer formed on the lateral side thereof through the steps of firstly subjecting the thermoplastic resin constituting the frame body to melt injection molding into a primary mold with an injection molding machine for exclusive use to obtain a frame body ( primary molding ) of a thermoplastic resin molding having a hole and/or notch portion; solidifying the frame body; allowing the solidified body to remain in a mold on the mobile side ( mobile primary mold ) of two molds which form the primary mold; allowing the mobile primary mold to rotatably move so that the secondary mold engraved to the shape of the gasket covers the primary mold, at which time a space in the shape of the gasket is formed with the combination of the secondary mold and the mobile primary mold, since the frame body still remains at a prescribed position in the mobile primary mold; and then subjecting the thermoplastic elastomer which is excellent in fusion adhesivity to said thermoplastic resin, to melt injection molding into said space with an injection molding machine for exclusive use so as to form a gasket portion composed of the thermoplastic elastomer layer. The two-color molding method is capable of producing gasket fitted to a frame in high production efficiency at a low cost.

In the gasket fitted to a frame (V ) according to the present invention, it is made possible to dispense with a rust preventive step and reduce the weight of the product owing to the nonuse of a metallic material, whereby the gasket fitted to a frame (V ) is well suited for use in compactified hard disc units. Further it is made possible to efficiently produce the same using a single mold in high accuracy and precision at a low cost owing to the use of a synthetic resin, and to recycle said resin.

As the material constituting a cover body or a box body in which is used the gasket fitted to a frame (V ) according to the present invention, there are usable various synthetic resins typified by the above-mentioned thermoplastic resins, metals such as aluminum, iron, stainless steel and magnesium, alloys and the like.

As described hereinbefore, the gasket fitted to a frame (V ) according to the present invention is lightweight and has excellent sealing properties without causing dislocation of the frame body due to molding contraction in the mold.

As the synthetic resin constituting the frame body and the positioning portion in the gasket fitted to a frame (VI ) according to the present invention, there are preferably usable the synthetic resins same as those exemplified in the gasket fitted to a frame (I ). Moreover, as the thermoplastic elastomer constituting the gasket in the gasket fitted to a frame (VI ), there are preferably usable the thermoplastic elastomer same as those exemplified in the gasket fitted to a frame (I ). Likewise, as fillers capable of imparting electroconductivity and reinforcing materials, there are preferably usable those exemplified in the gasket fitted to a frame (I ). The volume resistivity and JIS hardness A are each preferably in the same range as in the gasket fitted to a frame (I ).

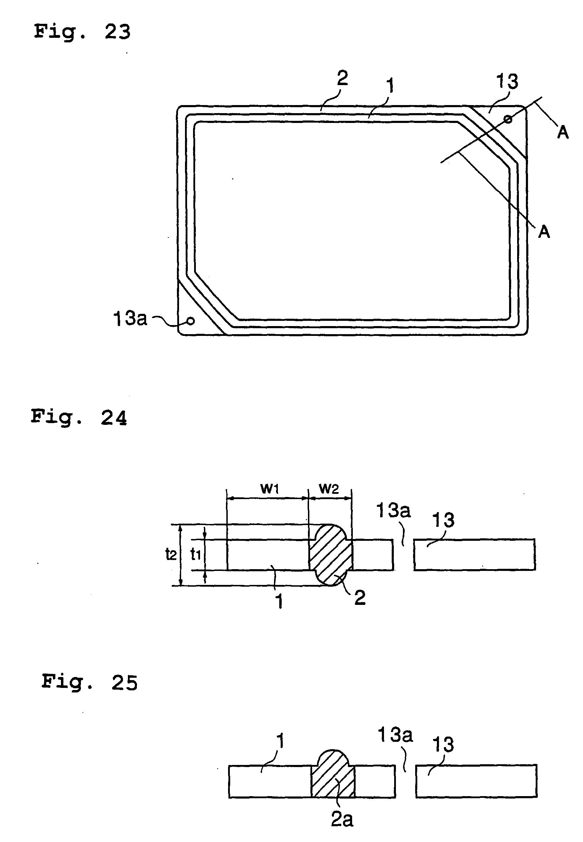

In the gasket fitted to a frame (VI ) according to the present invention, the gasket is fixed to the lateral side of the frame body and the positioning portion, and is interposed on the joint surface between a box body housing integrated circuit, etc. and a cover body. FIG.23 is a plan view which shows one example of gasket fitted to a frame (VI ) according to the present invention, and FIG.24 is an enlarged cross sectional view taken on the line A-A of FIG.23. As illustrated in FIG.24 it is made possible to impart rigidity for the purpose of retaining the shape by fixing the gasket 2 to the lateral side of the frame body 1 through increased thickness of the frame body 1 without increasing the total thickness (represented by t₂ in FIG.24) of the gasket 2 and besides, to shape the gasket 2 into a desirable configuration for satisfying sealing properties. It is further made possible to perform correct positioning of the gasket for the box body at the time of inserting the gasket fitted to a frame into the box body by installing a positioning portion composed of the synthetic resin same as that of the frame body on the gasket lateral side in the opposite lateral side where gasket is fixed onto the frame body.

As illustrated in FIG.23 and 24, the gasket fitted to a frame is equipped with a positioning portion 13 of a hole 13a, which may be replaced with a notch. Such hole and/or notch can be formed by setting up a pin at the position corresponding to the hole and/or notch in a mold at the time of forming the positioning portion 13. The sizes of the hole and/or notch to be formed at the positioning portion 13 can be properly arbitrarily selected. The hole usually has a diameter of 0.5 to 2.0 mm, and the notch is made to a partial configuration of the hole.

The positioning at the time of inserting the gasket fitted to a frame having such positioning portion into the box body, can be put into practice by a method comprising inserting a convexed portion installed on the box body into a positioning hole, a method comprising making a hole in the box body, inserting the the gasket fitted to a frame in the box, thereafter causing the hole in the box body to coincide with a positioning hole, and inserting a pin through the holes from the upper side, and like methods.

In the gasket fitted to a frame (VI ), proper and arbitrary selection is made for the thickness {refer to t₁ in FIG.24} and width { refer to w₁ in FIG.24 } of the frame body, and total thickness { refer to t₂ in FIG.24 } and width { refer to w₂ in FIG.24 } of the gasket in accordance with the purpose of use of the gasket fitted to a frame and the like. In order to assure sufficient rigidity thereof, the frame body has a thickness of preferably at least 0.1 mm. In the case where the frame body has a thickness in the range of 0.1 to 1.2 mm, it can have a width of 0.5 to 5.0 mm, preferably 1.0 to 3.0 mm, the gasket can have a total thickness of 0.8 to 2.5 mm, preferably 1.2 to 1.8 mm and a width of 0.5 to 2.5 mm, preferably 0.8 to 1.5 mm.

On the one hand, the shape of the gasket may be convex both upwards and downwards for the frame body 1 as shown by the gasket 2 in FIG.24, or may be convex only upwards for the frame body 1 as shown by the gasket 2a in FIG.25 therefor.

The integration of the frame body and the gasket is made by the junction between the thermoplastic resin constituting the frame body and the thermoplastic elastomer constituting the gasket, specifically by two-color molding method, inserting molding method or the like. The details of these methods are as explained in the description of the gasket fitted to a frame (I ).

The gasket fitted to a frame (VI ) according to the present invention has such configuration that the gasket is fixed to the lateral side of the frame body and at the same time, a positioning portion composed of the synthetic resin same as that of the frame body is fixed onto the gasket lateral side in the opposite lateral side where the gasket is fixed onto the frame body. Such configuration is enabled merely by the integration by fused adhesion of the frame body comprising the synthetic resin and the gasket comprising the elastic body, but is extremely difficult to realize with a conventional gasket fitted to a metallic frame or a punched product comprising a resin sheet and a foam.

In the gasket fitted to a frame (VI ) according to the present invention, it is made possible to dispense with a rust preventive step and reduce the weight of the product owing to the nonuse of a metallic material, whereby the gasket fitted to a frame (VI ) is well suited for use in compactified hard disc units. Further it is made possible to efficiently produce the same using a single mold in high accuracy and precision at a low cost owing to the use of a synthetic resin, and to recycle said resin.

As the material constituting a cover body or a box body in which is used the gasket fitted to a frame (VI ) according to the present invention, there are usable various synthetic resins typified by the above-mentioned thermoplastic resins, metals such as aluminum, iron, stainless steel and magnesium, alloys and the like.

As described hereinbefore, the gasket fitted to a frame (VI ) according to the present invention has a lightweight property; satisfies both rigidity and sealing properties; can be installed in a small clearance; can correctly be inserted in a prescribed position in a box body; and never causes dislocation of the gasket even when a cover body is placed on the gasket.

In what follows, the present invention will be described in further detail with reference to comparative examples and working examples, which however shall never limit the present invention thereto.

### Example 1

By two-color molding method along with the following procedure, there were prepared the gasket fitted to a frame as illustrated in FIG.1 and FIG.2 in which the frame body 1 had a thickness (t₁) 0.7 mm and a width (w₁) of 2.0 mm and the gasket 2 had a total thickness (t₂) of 1.4 mm and a width (w₂) of 1.0 mm. As the thermoplastic resin constituting the frame body 1, there was used polypropylene (manufactured by Sumitomo Chemical Co.,Ltd. under the trade name " Noblen Y101 "). The thermoplastic elastomer constituting the gasket was prepared by kneading 100 parts by weight of SEPS having a number-average molecular weight of 100,000 and styrene moiety content of 30% by weight, 150 parts by weight of paraffin base oil having a kinematic viscosity at 40°C of 380 mm²/sec ( manufactured by Idemitsu Kohsan Co.,Ltd. under the trade name " Diana Process Oil PW 380 " having a weight-average molecular weight of 750 ) and 12.5 parts by weight of polypropy- lene ( manufactured by Sumitomo Chemical Co.,Ltd. under the trade name " Noblen Y101 "). The thermoplastic elastomer thus obtained had a JIS hardness A of 22 degrees.

Specifically, by the use of an injection molding machine ( manufactured by Nissei Plastic Industrial Co.,Ltd. under the trade name "DC 60E 5ASE"), the above prepared thermoplastic resin for the frame body was subjected to melt injection molding into a mold at a mold temperature of 40°C and a resin temperature of 180°C with a result that the obtained frame body had a weight of 0.70g. Then the above prepared thermoplastic elastomer for the gasket was subjected to melt injection molding onto the frame body in the mold at a mold temperature of 40°C and a resin temperature of 230°C. After all, there was prepared 1.30g of gasket fitted to the frame body wherein the gasket was integrated with the frame body. As compared with the gasket fitted to the frame body having a total weight of 2.0g (frame body weighed 1.2g) in the under mentioned Comparative Example 1, weight reduction of at least 40% was enabled thereby. The resultant gasket fitted to the frame body had a flexural strength almost same as that in Comparative Example 1.

The gasket fitted to the frame body as prepared in the above mentioned manner was used while being inserted into the clearance of 1.1 mm between a box body housing a hard disc unit of a computer and a cover body. As a result, sufficient sealing property was preserved for a long period of time.

### Comparative Example 1

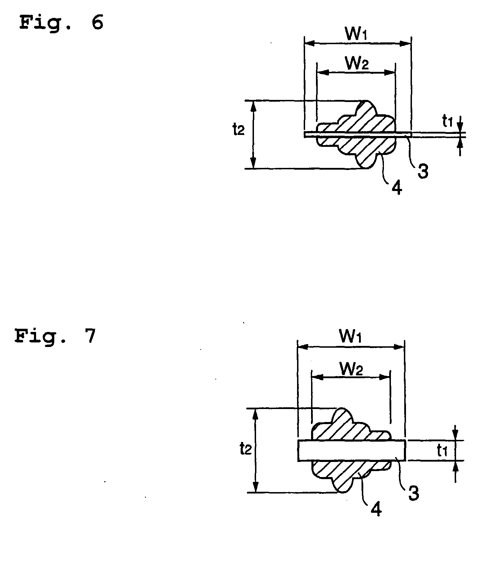

By the use of a stainless steel made flat sheet with a thickness of 0.13 mm as a frame body 3, and the thermoplastic elastomer same as in Example 1 as the gasket, there was prepared the gasket fitted to the frame body as shown in FIG.6 in which the frame body 3 had a thickness (t₁) of 0.13 mm and a width (w₁) of 2.5 mm, and the gasket had a total thickness (t₂) of 1.6 mm and a width (w₂) of 1.8 mm, by means of inserting molding method as described hereunder.

Specifically, by the use of an injection molding machine ( manufactured by Nissei Plastic Industrial Co.,Ltd. under the trade name "TH 30 R5 VSE"), the above prepared frame body made of stainless steel was inserted into a mold attached to said molding machine, and thermoplastic elastomer for the gasket was subjected to melt injection molding onto the frame body in the mold at a mold temperature of 50°C and a resin temperature of 230°C. After all, there was prepared a gasket fitted to the frame body wherein the gasket and the frame body were integratedly composited with each other. Because of the frame body made of stainless steel, the gasket fitted to the frame body had a total weight of 2.0g (frame body weighed 1.2g), which was much larger than that in Example 1.

### Comparative Example 2

By the use of the thermoplastic resin constituting the the frame body 3 and the thermoplastic elastomer constituting the gasket 4 each being same as in Example 1, there was prepared the gasket fitted to the frame body as shown in FIG.7 in which the frame body 3 had a thickness (t₁) of 0.6 mm and a width (w₁) of 2.5 mm, and the gasket had a total thickness (t₂) of 2.0 mm and a width (w₂) of 1.8 mm, by means of two-color molding method in the same manner as in Example 1.

In the gasket fitted to the frame body, in order to assure sufficient rigidity of the frame body composed of polypropylene, the thickness thereof was almost the same as that in Example 1, and the gasket having a sufficient thickness for maintaining sealing property was fixed to both sides of the the frame body 3. For this reason, the total thickness thereof was more than 1.4 times that in Example 1. Therefore, it is recognized that the present gasket fitted to the frame is extremely difficult to use by inserting into a narrow clearance of 1.1 mm, whereas such usage is made possible by the gasket fitted to the frame in Example 1.

### Example 2

By two-color molding method along with the following procedure, there were prepared the gasket fitted to a frame as illustrated in FIG.8 and FIG.9(A) which measured 95 mm× 140 mm in size and in which the outer frame body 1a, the inner frame body 1b and the rod body 1c had each a thickness (t₁) of 0.7 mm, the outer frame body 1a and the inner frame body 1b had each a width (w₁ and w₃) of 2.0 mm, the gaskets 2a and 2b had each a total thickness (t₂) of 1.4 mm and a width ( w₂ and w₄) of 1.0 mm, the inner frame body 1b had an outside diameter (w₅) of 10.0 mm and the rod body 1c had a width (w₆) of 2.0 mm. As the thermoplastic resin constituting the frame body 1a, 1b and the rod body 1c, there was used polypropylene (manufactured by Sumitomo Chemical Co.,Ltd. under the trade name "Noblen Y101"). The thermoplastic elastomer constituting the gasket was prepared by kneading 100 parts by weight of SEPS having a number-average molecular weight of 100,000 and styrene moiety content of 30% by weight, 150 parts by weight of paraffin base oil having a kinematic viscosity at 40°C of 380 mm²/sec (manufactured by Idemitsu Kohsan Co.,Ltd. under the trade name "Diana Process Oil PW 380" having a weight-average molecular weight of 750) and 12.5 parts by weight of polypropylene (manufactured by Sumitomo Chemical Co.,Ltd. under the trade name " Noblen Y101 "). The thermoplastic elastomer thus obtained had a JIS hardness A of 22 degrees.

Specifically, by the use of an injection molding machine ( manufactured by Nissei Plastic Industrial Co.,Ltd. under the trade name "DC 60E 5ASE"), the above prepared thermoplastic resin for the frame body was subjected to melt injection molding into a mold at a mold temperature of 40°C and a resin temperature of 180°C with a result that the obtained frame body had a weight of 0.80g. Then the above prepared thermoplastic elastomer for the gasket was subjected to melt injection molding onto the frame body in the mold at a mold temperature of 40°C and a resin temperature of 230°C. After all, there was prepared 1.40g of gasket fitted to the frame body wherein the gasket was integrated with the frame body. As compared with the gasket fitted to the frame body in the under mentioned Comparative Example 3 which had a total weight of 2.0g (frame body weighed 1.2g) and which was in the form of sealing the outer periphery only, weight reduction of about 35% was enabled thereby. The resultant gasket fitted to the frame body had a flexural strength almost same as that in Comparative Example 3.

The gasket fitted to the frame body as prepared in the above mentioned manner was used while being inserted into the clearance of 1.1 mm between a box body housing a hard disc unit of a computer and a cover body. As a result, sufficient sealing property was preserved for a long period of time.

### Comparative Example 3

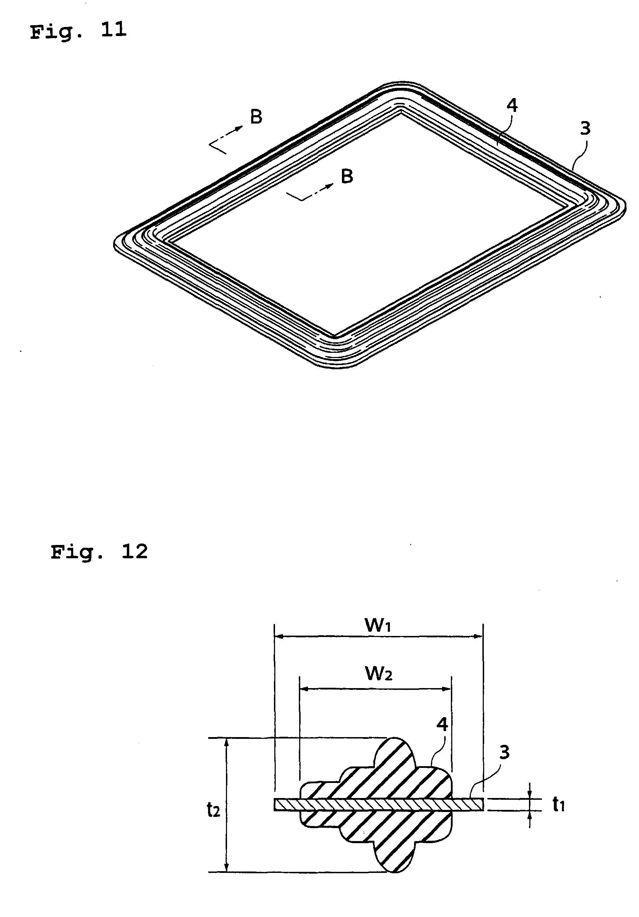

By the use of a stainless steel made flat sheet with a thickness of 0.13 mm as a frame body 3, and the thermoplastic elastomer same as in Example 2 constituting the gasket, there was prepared the gasket fitted to the frame body as shown in FIG.11 and FIG.12 in which the frame body 3 had a thickness (t₁) of 0.13 mm and a width (w₁) of 2.5 mm, and the gasket had a total thickness (t₂) of 1.6 mm and a width (w₂) of 1.8 mm, by means of inserting molding method as described hereunder.

Specifically, by the use of an injection molding machine ( manufactured by Nissei Plastic Industrial Co.,Ltd. under the trade name "TH 30 R5 VSE"), the above prepared frame body made of stainless steel was inserted into a mold attached to said molding machine, and the aforesaid thermoplastic elastomer for the gasket was injection molded onto the frame body in the mold at a mold temperature of 50°C and a resin temperature of 230°C. After all, there was prepared a gasket fitted to the frame body wherein the gasket and the frame body were integratedly composited with each other. Because of the frame body made of stainless steel, the gasket fitted to the frame body had a total weight of 2.0g (frame body weighed 1.2g), which was much larger than that in Example 2.

### Example 3

By two-color molding method with the following procedure, there were prepared the gasket fitted to a frame as illustrated in FIG.13 and FIG.14 in which the frame body 1 had a thickness (t₁) of 0.7 mm and a width (w₁) of 2.0 mm, the gasket 2 had a total thickness (t₂) of 1.4 mm and a width (w₂) of 1.5 mm, and the protruding portion a placed on the frame body 1 had a height of 0.02 mm. As the thermoplastic resin constituting the frame body 1, there was used polypropylene (manufactured by Sumitomo Chemical Co.,Ltd. under the trade name " Noblen Y101 "). The thermoplastic elastomer constituting the gasket was prepared by kneading 100 parts by weight of SEPS having a number-average molecular weight of 100,000 and styrene moiety content of 30% by weight, 150 parts by weight of paraffin base oil having a kinematic viscosity at 40°C of 380 mm²/sec (manufactured by Idemitsu Kohsan Co.,Ltd. under the trade name " Diana Process Oil PW 380" having a weight-average molecular weight of 750) and 12.5 parts by weight of polypropylene ( manufactured by Sumitomo Chemical Co.,Ltd. under the trade name "Noblen Y101"). The thermo- plastic elastomer thus obtained had a JIS hardness A of 22 degrees.

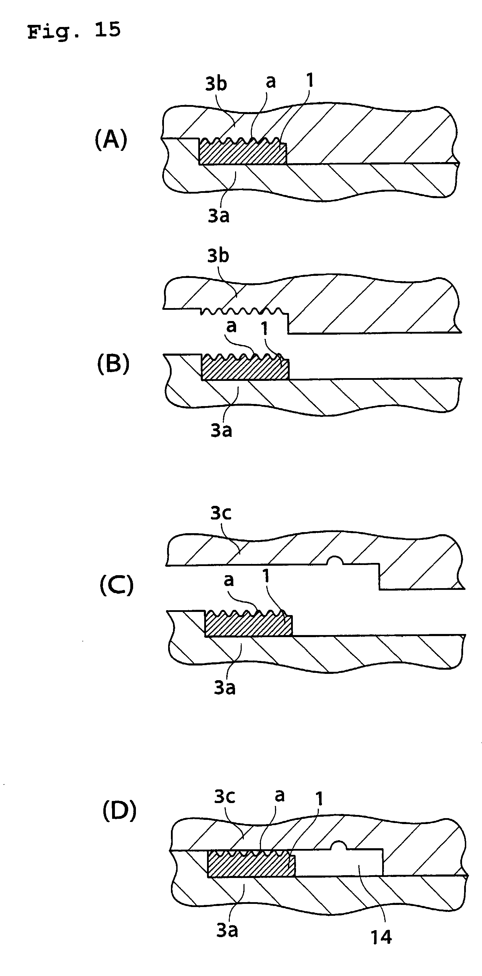

The above-mentioned gasket fitted to a frame was prepared according to the process as illustrated in FIG.15. The thermoplastic resin for the frame body was subjected to melt injection molding into molds 3a and 3b at a mold temperature of 40°C and a resin temperature of 180°C with a result that the obtained molding ( frame body 1 ) had a protrusion on the surface thereof {refer to FIG.15 (A)}. When the mold 3a and the mold 3b were separated from each other after the injection molding, the molding ( frame body 1 ) was left in the side of the mold 3a {refer to FIG.15 (B)}, thereafter the mold 3a was moved and was covered with the mold 3c for forming a gasket {refer to FIG.15 (C)}, and the thermoplastic elastomer for the gasket was subjected to melt injection molding into the cavity 14 {refer to FIG.15 (D)} formed with the mold 3a and the mold 3c at a mold temperature of 40°C and an elastomer temperature of 230°C so as to prepare the gasket fitted to the frame body wherein the gasket and the frame body were integrated with each other. As illustrated in FIG.15 (D), even when the mold 3a and the mold 3c were closed, slight clearance was allowed to exist between the mold 3c and the molding ( frame body 1 ) by the protrusions continuously arranged on the surface of the molding, thereby making it possible to exhaust air and gases in the cavity 14 to the outside of the mold. Moreover, no dent was observed on the resultant gasket at the place corresponding to the weld portion of the mold. The gasket fitted to the frame body as prepared in the above-mentioned manner was used while being inserted into the clearance of 1.1 mm between a box body housing a hard disc unit of a computer and a cover of the box body. As a result, sufficient sealing property was preserved for a long period of time.

### Example 4

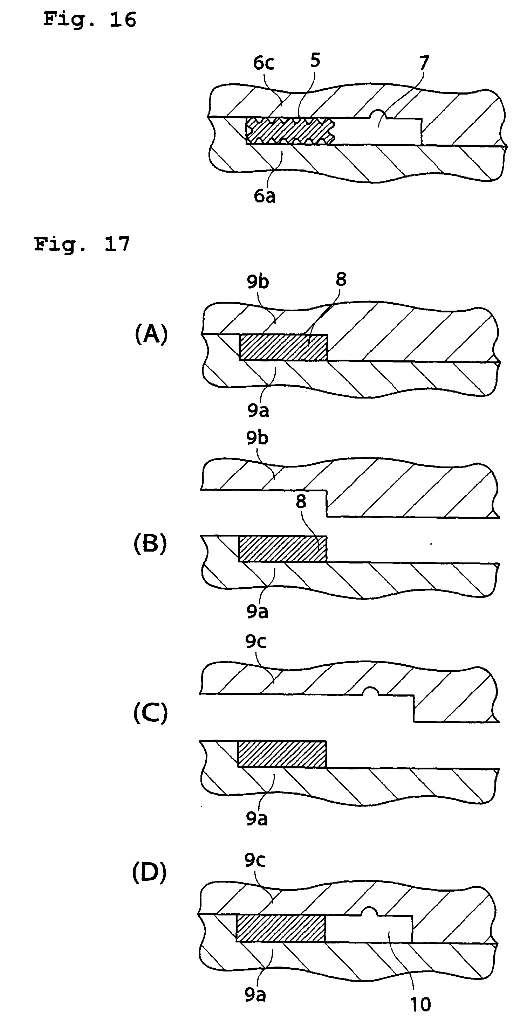

As illustrated in FIG.16, there was prepared the frame body 5 having protrusions same as in Example 3 continuously arranged on three molding surfaces thereof by the use of the thermoplastic resin same as in Example 3. By the use of an injection molding machine ( manufactured by Nissei Plastic Industrial Co.,Ltd. under the trade name "TH 30 R5 VSE"), the above prepared frame body 5 was inserted into molds 6a, 6c attached to said molding machine, and the thermoplastic elastomer same as in Example 3 for the gasket was injection molded in the cavity 7 at a mold temperature of 50°C and a resin temperature of 230°C. After all, there was prepared a gasket fitted to the frame body same as in Example 3.

Since uneven irregular portions can be installed on three molding surfaces in the case of inserting molding, enhanced effect was exhibited on exhausting air and gases in the cavity 7 to the outside. The gasket fitted to the frame body as prepared in the above-mentioned manner was used while being inserted into the clearance of 1.1 mm between a box body housing a hard disc unit of a computer and a cover of the box body. As a result, sufficient sealing property was preserved for a long period of time.

### Comparative Example 4

By the use of the thermoplastic resin constituting the frame body 8, and the thermoplastic elastomer constituting the gasket each same as in Example 3, there was prepared the gasket fitted to the frame body by means of two-color molding method same as in Example 3. The frame body 8 had a thickness (refer to t₁ in FIG.14) of 0.7 mm and a width (refer to w₁ in FIG.14) of 2.0 mm, the gasket 2 had a total thickness (refer to t₂ in FIG.14) of 1.4 mm and a width (refer to w₂ in FIG.14) of 1.5 mm. The production process is illustrated in FIG.17, in which the molds 9a and 9c as shown in (C) and (D), respectively have the shape same as in the molds 3a and 3c, respectively as illustrated in FIG.15, but the mold 9b as shown in (A) and (B) is different from the mold 3b as illustrated in FIG.15, in that the mold 9b is devoid of the configuration for forming a protruding portion. Accordingly, uneven irregular portions are not formed on the molding surfaces in the frame body 8, as illustrated in FIG.17 (D), when the molds 9a and 9c are closed, no clearance is generated between the mold 9a and the molding ( the frame body 8) nor between the mold 9c and the molding, thereby making it possible to exhaust air and gases in the cavity 10 to the outside of the mold.

In the gasket fitted to the frame thus prepared, gasket dent was generated at the portion corresponding to the weld portion of the mold. Said gasket fitted to the frame body was used while being inserted into the clearance of 1.1 mm between a box body housing a hard disc unit of a computer and a cover of the box body. As a result, because of poor water sealing property foreign matters were stuck to the surface of the hard disc unit, thus causing malfunction.

### Example 5

By two-color molding method along with the following procedure, there were prepared the gasket fitted to a frame as illustrated in FIG.18 and FIG.19 in which the frame body 1 had a thickness (t₁) 0.7 mm and a width (w₁) of 2.0 mm, the gasket 2 had a total thickness (t₂) of 1.4 mm and a width (w₂) of 1.5 mm, and the holes 11a made in the the frame body 1 had each a diameter of 1.2 mm . As the thermoplastic resin constituting the frame body 1, there was used polypropylene (manufactured by Sumitomo Chemical Co.,Ltd. under the trade name " Noblen Y101 "). The thermoplastic elastomer constituting the gasket was prepared by kneading 100 parts by weight of SEPS having a number-average molecular weight of 100,000 and styrene moiety content of 30% by weight, 150 parts by weight of paraffin base oil having a kinematic viscosity at 40°C of 380 mm²/sec (manufactured by Idemitsu Kohsan Co.,Ltd. under the trade name " Diana Process Oil PW 380 " having a weight-average molecular weight of 750 ) and 12.5 parts by weight of polypropylene ( manufactured by Sumitomo Chemical Co.,Ltd. under the trade name " Noblen Y101 "). The thermoplastic elastomer thus obtained had a JIS hardness A of 22 degrees.

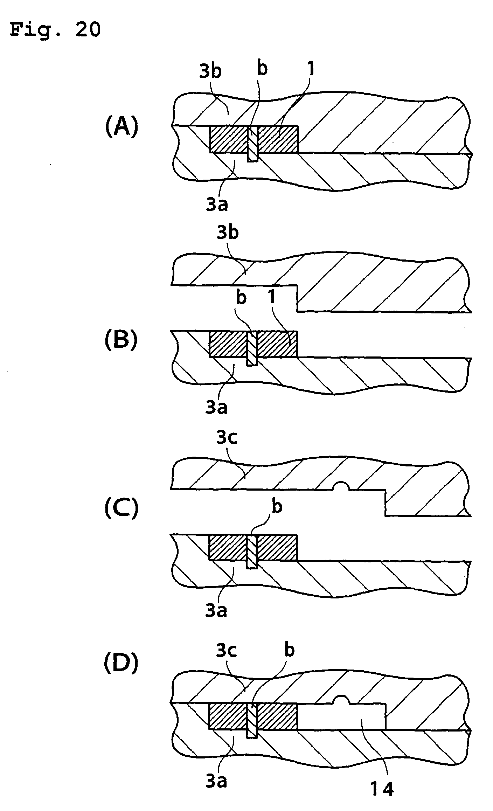

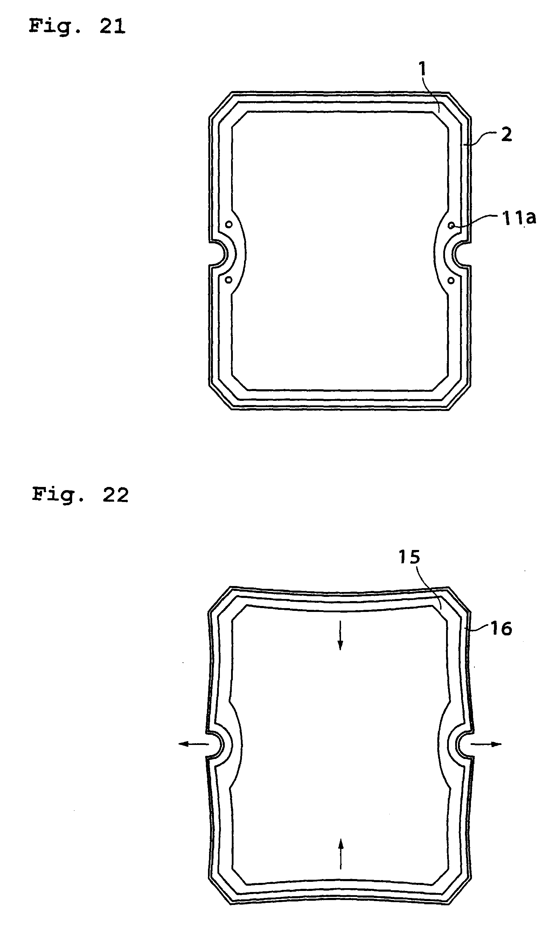

The above-mentioned gasket fitted to a frame was prepared according to the process as illustrated in FIG.20. The thermoplastic resin for the frame body was subjected to melt injection molding into molds 3a in which were set up pins b for forming holes 11a and 3b (primary molds) at a mold temperature of 40°C and a resin temperature of 180°C {refer to FIG.20(A)}. When the mold 3a and the mold 3b were separated from each other after the injection molding, the molding (frame body 1 ) was left in the side of the mold 3a ( mobile primary mold) {refer to FIG.20(B)}, thereafter the mold 3a was rotatably moved and was covered by the mold 3c for forming a gasket {refer to FIG.20(C)}, and the thermoplastic elastomer for the gasket was subjected to melt injection molding into the cavity 14 {refer to FIG.20(D)} formed with the mold 3a and the mold 3c at a mold temperature of 40°C and an elastomer temperature of 230°C so as to prepare the gasket fitted to the frame body wherein the gasket and the frame body were integrated with each other. As illustrated in the plan view of FIG.21, the resultant gasket fitted to the frame body was free from any deformation in its configuration, and had outside dimensions almost exactly the same as those of original design.

Said gasket fitted to the frame body was used while being inserted into the clearance of 1.1 mm between a box body housing a hard disc unit of a computer and a cover of the box body. As a result, sufficient sealing property was preserved for a long period of time.

### Comparative Example 5

A gasket fitted to a frame body without any hole 11a as formed in Example 5 in the frame body 1 was prepared in the same manner as in Example 1. As a result as illustrated in FIG.22 in which the symbol 15 was the frame body and the symbol 16 was gasket, the resultant gasket fitted to the frame body as shown in FIG.21 was deformed in the directions of the arrows. The cause of such deformation was attributable to the fact that when the mold 3a was rotatably moved to the direction of the mold 3c in the process in FIG.20(C), the molding (the frame body 15) was deformed by the shrinkage thereof, causing dislocation from the mold 3a, and accordingly when the mold 3c covered the mold 3a, the cavity 4 was brought to the state that its gasket configuration was not assured. Therefore the gasket fitted to the frame body which was prepared by filling the thermoplastic elastomer, molding and releasing from the mold in the above-mentioned state resulted in a size about 3 mm larger based on the total width of 100 mm, and was totally deformed. Thus there was caused such trouble that the it was impossible to insert the gasket fitted to the frame body in a box body housing a hard disc unit of a computer.

### Example 6

By two-color molding method along with the following procedure, there were prepared the gasket fitted to a frame as illustrated in FIG.23 and FIG.24 in which the frame body 1 had a thickness (t₁) 0.7 mm and a width (w₁) of 2.0 mm and the gasket 2 had a total thickness (t₂) of 1.4 mm and a width (w₂) of 1.0 mm. As the thermoplastic resin constituting the frame body 1 and the positioning portion 13, there was used polypropylene ( manufactured by Sumitomo Chemical Co.,Ltd. under the trade name "Noblen Y101" ). The thermoplastic elastomer constituting the gasket was prepared by kneading 100 parts by weight of SEPS having a number-average molecular weight of 100,000 and styrene moiety content of 30% by weight, 150 parts by weight of paraffin base oil having a kinematic viscosity at 40°C of 380 mm²/sec ( manufactured by Idemitsu Kohsan Co.,Ltd. under the trade name " Diana Process Oil PW 380" having a weight-average molecular weight of 750 ) and 12.5 parts by weight of polypropylene ( manufactured by Sumitomo Chemical Co.,Ltd. under the trade name " Noblen Y101" ). The thermoplastic elastomer thus obtained had a JIS hardness A of 22 degrees.

Specifically, by the use of an injection molding machine ( manufactured by Nissei Plastic Industrial Co.,Ltd. under the trade name "DC 60E 5ASE"), the above prepared thermoplastic resin for the frame body was subjected to melt injection molding into a mold at a mold temperature of 40°C and a resin temperature of 180°C, to prepare the frame body and positioning portion. Then the above prepared thermoplastic elastomer for the gasket was subjected to melt injection molding in the mold at a mold temperature of 40°C and a resin temperature of 230°C. After all, there was prepared 1.5g of gasket fitted to the frame body wherein the frame body, gasket and positioning portion were integrated with one another.

The gasket fitted to the frame body as prepared in the above-mentioned manner was used while the protruding portions installed on a box body housing a hard disc unit of a computer were inserted into the holes in the positioning portion on the gasket fitted to the frame body so as to insert into the clearance of 1.1 mm between the box body and the cover body. As a result, sufficient sealing property was preserved for a long period of time.

## Claims

1. A gasket integrally fitted to a frame, characterized in that a frame body comprises a synthetic resin, the gasket comprises an elastic body, and said gasket is fixed to the lateral side of the frame body.

2. The gasket integrally fitted to a frame according to Claim 1, wherein the frame body is equipped with a fitting portion for fitting the frame body with a box body and/or a cover body.

3. The gasket integrally fitted to a frame according to Claim 1, wherein the a fitting portion is a protruding portion or hole portion.

4. The gasket integrally fitted to a frame according to Claim 1, wherein the synthetic resin constituting a frame body is a thermoplastic resin, the elastic body constituting the gasket is a thermoplastic elastomer, and the thermoplastic resin and the thermoplastic elastomer are integrated by fusion adhesion.

5. A process for producing the gasket integrally fitted to a frame as set forth in Claim 1, which comprises integrating the frame body and the gasket by two-color molding method.

6. A process for producing the gasket integrally fitted to a frame as set forth in Claim 1, which comprises integrating a frame body and the gasket by inserting molding method.

7. A gasket integrally fitted to a frame, characterized in that a frame body comprises an outer frame body and an inner frame body that are integrated with each other, and the gasket comprises an elastic body, and is integrated with said outer frame body and inner frame body.

8. The gasket integrally fitted to a frame according to Claim 7, wherein the frame body comprises a synthetic resin, and the gasket, the outer frame body and the inner frame body are integrated by fixing the gasket to the lateral sides of the outer frame body and the inner frame body.

9. A gasket integrally fitted to a frame, characterized in that the gasket comprises an elastic body, and is integrated with both the whole outer side of the frame body and part of the inner side thereof.

10. The gasket integrally fitted to a frame according to Claim 9, wherein the frame body comprises a synthetic resin, and the gasket is integrated with the frame body by fixing the gasket to the lateral sides of the outer frame body and the inner frame body.

11. The gasket integrally fitted to a frame according to Claim 8, wherein the synthetic resin constituting the frame body is a thermoplastic resin, the elastic body constituting the gasket is a thermoplastic elastomer, and the thermoplastic resin and the thermoplastic elastomer are integrated by fusion adhesion.

12. A process for producing the gasket integrally fitted to a frame as set forth in Claim 11, which comprises integrating the frame body and the gasket by two-color molding method.

13. A process for producing the gasket integrally fitted to a frame as set forth in Claim 11, which comprises integrating the frame body and the gasket by inserting molding method.

14. A gasket integrally fitted to a frame, characterized in that a frame body comprises a thermoplastic resin, the gasket comprises a thermoplastic elastomer, and uneven and irregular portions are installed on the molding surface of the frame body.

15. The gasket integrally fitted to a frame according to Claim 14, wherein the frame body and the gasket are integrated by the fusion adhesion between the thermoplastic resin constituting a frame body and the elastic body constituting the gasket.

16. A process for producing the gasket integrally fitted to a frame as set forth in Claim 14, which comprises integrating the frame body and the gasket by two-color molding method.

17. A process for producing the gasket integrally fitted to a frame as set forth in Claim 14, which comprises integrating the frame body and the gasket by inserting molding method.

18. A gasket integrally fitted to a frame, characterized in that a frame body comprises a thermoplastic resin, the gasket comprises a thermoplastic elastomer, and at least one hole and/or at least one notch are each installed in the frame body.

19. The gasket integrally fitted to a frame according to Claim 18, wherein the frame body and the gasket are integrated by the fusion adhesion between the thermoplastic resin constituting a frame body and the elastic body constituting the gasket.

20. A process for producing the gasket integrally fitted to a frame as set forth in Claim 18 , which comprises integrating the frame body and the gasket by two-color molding method.

21. A gasket integrally fitted to a frame, characterized in that a frame body comprises a synthetic resin, the gasket comprises a thermoplastic elastomer, said gasket is fixed on the lateral side of the frame body, and further a positioning portion composed of the synthetic resin same as that of the frame body is fixed onto the gasket lateral side in the opposite lateral side where the gasket is fixed onto the frame body.

22. The gasket integrally fitted to a frame according to Claim 21, wherein the positioning portion is a portion where at least one hole and/or notch are installed.

23. The gasket integrally fitted to a frame according to Claim 21, wherein the synthetic resin constituting the frame body is a thermoplastic resin, the elastic body constituting the gasket is a thermoplastic elastomer, and the thermoplastic resin and the thermoplastic elastomer are integrated by fusion adhesion.

24. A process for producing the gasket integrally fitted to a frame as set forth in Claim 21, which comprises integrating the frame body and the gasket by two-color molding method.

25. A process for producing the gasket integrally fitted to a frame as set forth in Claim 21, which comprises integrating the frame body and the gasket by inserting molding method.
